(19) Europäisches Patentamt
European Patent Office
Office européen des brevets

(11) EP 3 686 938 A1

(12) EUROPEAN PATENT APPLICATION
published in accordance with Art. 153(4) EPC

(43) Date of publication:
29.07.2020 Bulletin 2020/31

(51) Int Cl.:
H01L 31/048 (2014.01)

(21) Application number: 18858575.6

(86) International application number:
PCT/JP2018/033863

(22) Date of filing: 12.09.2018

(87) International publication number:
WO 2019/059072 (28.03.2019 Gazette 2019/13)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 19.09.2017 JP 2017179347

(71) Applicant: Toyo Aluminium Kabushiki Kaisha
Osaka-shi, Osaka 541-0056 (JP)

(72) Inventors:
• FUJINO, Takaaki
  Osaka-shi, Osaka 541-0056 (JP)
• MAEDA, Daisuke
  Osaka-shi, Osaka 541-0056 (JP)
• SAKAMOTO, Hiroyuki
  Osaka-shi, Osaka 541-0056 (JP)
• IMAMURA, Takahiro
  Osaka-shi, Osaka 541-0056 (JP)
• TANAKA, Soichiro
  Osaka-shi, Osaka 541-0056 (JP)

(74) Representative: Nieuwenhuys, William Francis
Marks & Clerk LLP
15 Fetter Lane
London EC4A 1BW (GB)

(54) SOLAR CELL MODULE

(57) This invention provides a solar cell module in which cell cracking during transportation, during installation, and after installation is reduced, even when a thin surface glass is used for weight reduction. More specifically, the invention provides a solar cell module comprising, in sequence from a light-receiving surface side, a surface glass layer having a thickness of 0.8 mm or more and 1.6 mm or less, a first sealing layer, cells, a second sealing layer, and a back protective layer, wherein
(1) the back protective layer comprises, in sequence from a side closer to the second sealing layer, a first thermoplastic resin layer being in a foam state and having a flexural modulus of 200 MPa or more and 1000 MPa or less, and a second thermoplastic resin layer containing glass fiber and having a flexural modulus of 10000 MPa or more and 25000 MPa or less; and
(2) the sum of flexural rigidity of each of the surface glass layer, the first sealing layer, the second sealing layer, and the back protective layer is 4000 MPa or more, the flexural rigidity being defined by:
{(flexural modulus (MPa) $\times$ thickness (mm)$^3$)/12}.

Fig. 1

EP 3 686 938 A1

**Description**

Technical Field

The present invention relates to a solar cell module.

Background Art

Solar cell modules usually have a structure in which a surface glass having a thickness of about 3.2 mm or more and 4.2 mm or less, a sealing material, crystalline silicon solar cells, a sealing material, and a back protective sheet are layered in sequence. Since these crystalline solar cell modules have a weight of about 18 kg per sheet, there can be restrictions on the installation thereof. For example, it is difficult for a solo operator to install modules in a high place; and due to load-bearing restrictions, solar cell modules sometimes cannot be laid over the surface of the roof of a simple structure, such as a carport.

In view of these problems, a technique in which the thickness of the surface glass, which accounts for most of the weight of a solar cell module, is reduced to less than 1.5 mm (e.g., Patent Literature (PTL) 1); and a technique in which the surface is covered with a resin film without using surface glass (e.g., PTL 2) have been developed.

Citation List

Patent Literature

PTL 1: JP2012-519967A
PTL 2: JP2015-502659A

Summary of Invention

Technical Problem

However, the technique of PTL 1, in which the thickness of the surface glass is simply reduced, has a problem such that the rigidity of the solar cell module is deteriorated, and cell cracking occurs during transportation or installation of the solar cell module. Further, the technique of PTL 2, in which the surface glass is replaced with a resin film while a support layer stack comprising a foam layer is provided on the back-surface side to improve the rigidity, has a problem such that cell cracking occurs due to the absence of surface glass when hail hits the module.

Therefore, an object of the present invention is to provide a solar cell module in which cell cracking is reduced during transportation, during installation, and after installation, even when a thin surface glass is used for weight reduction.

Solution to Problem

The present inventors conducted extensive research to achieve the object, and found that a solar cell module having a structure comprising at least a surface glass layer, a first sealing layer, cells, a second sealing layer, and a back protective layer can achieve the above object even when a thin surface glass layer (thickness: 0.8 mm or more and 1.6 mm or less) is used for weight reduction, by using a specific back protective layer and by setting the sum of flexural rigidity of each of the surface glass layer, the first sealing layer, the second sealing layer, and the back protective layer to a value equal to or greater than a specific value. The present invention has thus been completed.

More specifically, the present invention relates to the following solar cell module.

1. A solar cell module comprising, in sequence from a light-receiving surface side, a surface glass layer having a thickness of 0.8 mm or more and 1.6 mm or less, a first sealing layer, cells, a second sealing layer, and a back protective layer, wherein

(1) the back protective layer comprises, in sequence from a side closer to the second sealing layer, a first thermoplastic resin layer being in a foam state and having a flexural modulus of 200 MPa or more and 1000 MPa or less, and a second thermoplastic resin layer containing glass fiber and having a flexural modulus of 10000 MPa or more and 25000 MPa or less; and

(2) the sum of flexural rigidity of each of the surface glass layer, the first sealing layer, the second sealing layer, and the back protective layer is 4000 Mpa·mm$^3$ or more, the flexural

```
rigidity being defined by:

{(flexural modulus (MPa) × thickness (mm)³)/12}.
```

2. The solar cell module according to Item 1, wherein the first thermoplastic resin layer contains a foam body of at least one resin selected from the group consisting of polyethylene, polypropylene, polystyrene, polyurethane, polyethylene terephthalate, polyvinyl chloride, and polymethyl methacrylate.

3. The solar cell module according to Item 1 or 2, wherein the second thermoplastic resin layer contains a glass fiber-reinforced resin comprising a mixture of glass fiber and at least one resin selected from the group consisting of polyethylene, polypropylene, polyamide, polyurethane, polycarbonate, polymethyl methacrylate, polyethylene terephthalate, polybutylene terephthalate, acrylonitrile styrene, acrylonitrile butadiene styrene, polyacetal, polyphenylene sulfide, polyether sulfone, polyether ether ketone, and fluororesin.

4. The solar cell module according to any one of Items 1 to 3, wherein the first thermoplastic resin layer has a thickness of 2 mm or more and 6 mm or less, and a density of 100 kg/m$^3$ or more and 700 kg/m$^3$ or less.

5. The solar cell module according to any one of Items 1 to 4, wherein the second thermoplastic resin layer has a thickness of 0.5 mm or more and 2 mm or less, and contains the glass fiber in an amount of 30 wt% or more and 70 wt% or less.

Advantageous Effects of Invention

The solar cell module of the present invention, which has a specific structure, comprises a thin surface glass layer having a thickness of 0.8 mm or more and 1.6 mm or less for the purpose of weight reduction; nevertheless, cell cracking is reduced during transportation, during installation, and after installation (e.g., contact by hail).

Brief Description of Drawings

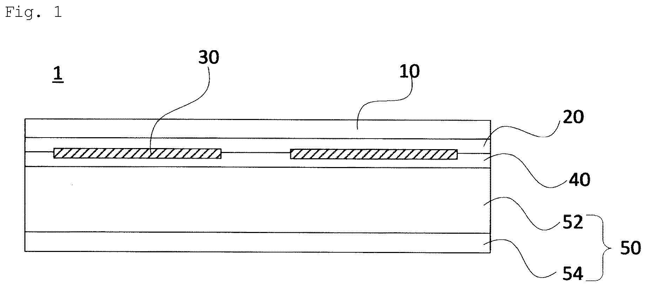

Fig. 1 is a cross-sectional view schematically illustrating one embodiment of the solar cell module according to the present invention.

Description of Embodiments

The solar cell module of the present invention comprises, in sequence from a light-receiving surface side, a surface glass layer having a thickness of 0.8 mm or more and 1.6 mm or less, a first sealing layer, cells, a second sealing layer, and a back protective layer,
wherein

(1) the back protective layer comprises, in sequence from a side closer to the second sealing layer, a first thermoplastic resin layer being in a foam state and having a flexural modulus of 200 MPa or more and 1000 MPa or less, and a second thermoplastic resin layer containing glass fiber and having a flexural modulus of 10000 MPa or more and 25000 MPa or less; and
(2) the sum of flexural rigidity of each of the surface glass layer, the first sealing layer, the second sealing layer, and the back protective layer is 4000 Mpa·mm$^3$ or more, the flexural rigidity being defined by:

```
{(flexural modulus (MPa) × thickness (mm)³)/12}.
```

The solar cell module of the present invention is described below with reference to Fig. 1. Fig. 1 is a cross-sectional view schematically illustrating one embodiment of the solar cell module of the present invention comprising, in sequence from a light-receiving surface side (sunlight incident side), a surface glass layer 10, a first sealing layer 20, cells 30, a second sealing layer 40, and a back protective layer 50. The back protective layer 50 comprises, in sequence from a side closer to the second sealing layer 40, a first thermoplastic resin layer 52 and a second thermoplastic resin layer 54.

In the present specification, for example, the side on which the surface glass layer 10 is positioned with respect to the cells 30 (i.e., the light-receiving surface side (sunlight incident side)) is sometimes also referred to as "top" or "front." Further, for example, the side on which the back protective layer is positioned with respect to the cells 30 is sometimes also referred to as "bottom" or "back."

The constituent features of the solar cell module according to the present invention are described below in detail.

Surface Glass Layer

In the present invention, the surface glass layer has a thickness of 0.8 mm or more and 1.6 mm or less (preferably 0.8 mm or more and 1.2 mm or less). The glass plate used for conventional and general solar cell modules has a thickness of about 3.2 mm or more and 4.2 mm or less. By using a surface glass layer having a thickness that is less than half of this thickness, significant weight reduction is possible compared to general solar cells.

Although the type of glass used for the surface glass layer is not particularly limited, physical toughened glass or chemical toughened glass is preferable. If the thickness of the glass layer is less than 0.8 mm, the glass may be broken in a hail test. Further, if the thickness of the glass layer exceeds 1.6 mm, the weight of the solar cell module exceeds, for example, a weight that is usually considered to be possible for a woman to work with on her own (body weight 55 kg $\times$ 60% $\times$ 40% $\approx$ 13 kg); thus, the installation may be restricted in the same manner as with general solar cell modules.

The surface glass layer preferably has a flexural rigidity defined by {(flexural modulus (MPa) $\times$ thickness (mm)$^3$)/12} of preferably 3000 Mpa·mm$^3$ or more and 25000 Mpa·mm$^3$ or less, and more preferably 3000 Mpa·mm$^3$ or more and 23000 Mpa·mm$^3$ or less.

Sealing Layer

In the present invention, the sealing layers sandwich the front and back surfaces of the cells. The material used for the sealing layers may be any sealing material usually used for sealing cells. In particular, EVA (ethylene-vinyl acetate copolymer) or a polyolefin-based sealing material is preferable. Other materials (additives) used for the sealing layers are not particularly limited, and known additives may be appropriately added to improve transparency, flexibility, adhesiveness, tensile strength, weatherability, and the like.

In the present invention, the first sealing layer is on the light-receiving surface side of the cells, while the second sealing layer is on the back side of the cells. However, both of these layers usually have substantially the same composition. When the cells are sealed, the first sealing layer and the second sealing layer are fused around the cells. Therefore, in the present invention, after sealing the cells, the first sealing layer and the second sealing layer are not necessarily clearly distinguished from each other, and can be regarded as a single sealing layer.

The sealing layer has a flexural rigidity defined by {(flexural modulus (MPa) $\times$ thickness (mm)$^3$)/12} of preferably 1 Mpa·mm$^3$ or more and 10 Mpa·mm$^3$ or less, and more preferably 5 Mpa· mm$^3$ or more and 10 Mpa·mm$^3$ or less. In the present specification, the flexural rigidity of the sealing layers refers to the flexural rigidity of a single sealing layer obtained after the first sealing layer and the second sealing layer are fused with each other. The cells present in the single sealing layer do not affect the flexural rigidity of the single sealing layer.

Cell

In the present invention, the cell is a semiconductor that converts the energy of light directly into electricity by the photovoltaic effect.

The type of the cell is not particularly limited, and the cell used may comprise a known semiconductor, such as a silicon (Si) semiconductor; a CIS compound semiconductor comprising copper (Cu), indium (In), and selenium (Se) as starting materials; a CIGS compound semiconductor comprising copper (Cu), indium (In), selenium (Se), and gallium (Ga) as starting materials; a compound semiconductor comprising cadmium (Cd) and tellurium (Te) as starting materials; and a GaAs compound semiconductor comprising gallium (Ga) and arsenic (As) as starting materials.

The cell may further comprise, on the surface or end face thereof, a known wiring or electrode for drawing electricity (interconnector, bus bar, etc.).

Back Protective Layer

In the present invention, the back protective layer is provided on the side opposite to the light-receiving surface side with respect to the cells (i.e., the back side); and comprises, in sequence from a side closer to the second sealing layer, a first thermoplastic resin layer being in a foam state and having a flexural modulus of 200 MPa or more and 1000 MPa or less, and a second thermoplastic resin layer containing glass fiber and having a flexural modulus of 10000 MPa or more and 25000 MPa or less.

In general solar cells, a layer called a back protective sheet (back sheet) is provided on the back surface of the solar cells; usually, a laminate of sheets of polyethylene terephthalate (PET), low-density polyethylene, vinylidene fluoride, etc. is used.

However, if a thin surface glass layer is used with such a back protective sheet as the back protective layer in a solar cell module, the rigidity of the solar cell module will be deteriorated, and cell cracking will occur during transportation, during installation, or after installation. On the other hand, the use of the back protective layer having the structure of the present invention on the back surface of the cells can increase the rigidity of the solar cell module comprising a thin surface glass layer.

In addition to the first thermoplastic resin layer and the second thermoplastic resin layer, the back protective layer may further appropriately comprise other layers as an interlayer or a surface layer to improve water resistance, power generation efficiency, and withstand voltage. For example, it is possible to provide at least one layer selected from the group consisting of an adhesion layer, a weather-resistant layer, and a reflection layer described later, at at least one position selected from: between the sealing layer and the first thermoplastic resin layer; between the first thermoplastic resin layer and the second thermoplastic resin layer; and on the back surface of the second thermoplastic resin layer.

The constituent features of the back protective layer are described below in detail.

First Thermoplastic Resin Layer

In the present invention, the first thermoplastic resin layer is present on a side closer to the second sealing layer, in positional relationship to the second thermoplastic resin layer in the back protective layer. The first thermoplastic resin layer is composed of a resin layer in a foam state having a flexural modulus of 200 MPa or more and 1000 MPa or less.

The first thermoplastic resin layer may be a foam body having a flexural modulus within the above range. The type of the resin is not particularly limited. For example, a foam body of at least one resin selected from the group consisting of polyethylene, polypropylene, polystyrene, polyurethane, polyethylene terephthalate, polyvinyl chloride, and polymethyl methacrylate can be used. Of these resins, polypropylene is particularly preferable from the viewpoint of strength, heat distortion resistance, and weatherability.

The first thermoplastic resin layer is a foam body of these resins, and preferably has a thickness of 2 mm or more and 6 mm or less, and more preferably 3 mm or more and 5 mm or less. If the thickness of the first thermoplastic resin layer is less than 2 mm, rigidity cannot be obtained, and cell cracking may occur. Further, if the thickness of the first thermoplastic resin layer exceeds 6 mm, heat does not easily escape during the vacuum lamination step in the production of the solar cell module, which can generate residual thermal stress, possibly causing warping of the solar cell module.

The first thermoplastic resin layer preferably has a density of 100 kg/m$^3$ or more and 700 kg/m$^3$ or less. If the density of the first thermoplastic resin layer exceeds 700 kg/m$^3$, the layer becomes hard and heavy, and heat does not easily escape during the vacuum lamination step in the production of the solar cell module, which can generate residual thermal stress, possibly causing warping of the solar cell module.

Furthermore, if the density of the first thermoplastic resin layer is less than 100 kg/m$^3$, the layer becomes too soft, and cracking may occur due to the bending load in a load test; further, foam may be broken by hot-pressing at about 150°C in the vacuum lamination step in the production of the solar cell module.

Further, the first thermoplastic resin layer preferably has a flexural rigidity defined by {(flexural modulus (MPa) × thickness (mm)$^3$)/12} of 100 Mpa·mm$^3$ or more and 20000 Mpa·mm$^3$ or less, and more preferably 800 Mpa·mm$^3$ or more and 5000 Mpa·mm$^3$ or less.

The method for obtaining the first thermoplastic resin layer in a foam state is not limited. For example, known physical foaming or chemical foaming can be used. From the viewpoint of regulating foam particles, chemical foaming is preferable. Further, to obtain the first thermoplastic resin layer in a foam state, the foaming ratio is preferably 1.5 times or more and 8 times or less, and particularly preferably 2 times or more and less than 5 times. If the foaming ratio is less than 1.5 times, the density becomes 700 kg/m$^3$ or more, and warping may occur in the solar cell module in the vacuum lamination step as described above. If the foaming ratio is greater than 8 times, the density becomes 100 kg/m$^3$ or less, and cracking may occur due to the bending load in a load test; further, foam may be broken in the vacuum lamination step as described above.

Second Thermoplastic Resin Layer

In the present invention, the second thermoplastic resin layer of the back protective layer is a layer that is not in contact with the sealing layer, i.e., a layer on the side opposite to the light-receiving surface side. The second thermoplastic resin layer is composed of a resin layer containing glass fiber, and has a flexural modulus of 10000 MPa or more and 25000 MPa or less.

The second thermoplastic resin layer may be a layer that contains glass fiber and has a flexural modulus within the above range. The type of the resin is not particularly limited. For example, a mixture of glass fiber and at least one resin selected from the group consisting of polyethylene, polypropylene, polyamide, polyurethane, polycarbonate, polymethyl methacrylate, polyethylene terephthalate, polybutylene terephthalate, acrylonitrile styrene, acrylonitrile butadiene styrene, polyacetal, polyphenylene sulfide, polyethersulfone, polyetheretherketone, and fluororesin can be used, from the viewpoint of strength, heat distortion resistance, and weatherability.

The resin containing glass fiber is also called glass fiber-reinforced resin (also referred to as "glass FRP," or simply "FRP"), and is obtained by infiltrating fine glass fiber with the resin while maintaining the fiber directionality.

The type of glass contained in the second thermoplastic resin layer is not particularly limited. For example, a known glass fiber cloth, glass fiber mat, and the like can be used. From the viewpoint of strength and surface accuracy, plain-woven glass cloth is preferable.

The ratio of the glass fiber to the resin is not particularly limited. For example, glass fiber having an average thickness of 1 $\mu$m or more and 10 $\mu$m or less, and an average length of 1 mm or more and 20 mm or less is preferably contained in an amount of 30 wt% or more and 70 wt% or less in the second thermoplastic resin layer.

The second thermoplastic resin layer preferably has a thickness of 0.5 mm or more and 2 mm or less, and more preferably 0.5 mm or more and 1 mm or less.

If the thickness of the second thermoplastic resin layer is less than 0.5 mm, rigidity cannot be obtained, and cell cracking may occur. If the thickness of the second thermoplastic resin layer exceeds 2 mm, the adhesion surface may be lifted due to overly strong stiffness when bonding to other layers.

The second thermoplastic resin layer preferably has a density of 1500 kg/m$^3$ or more and 2500 kg/m$^3$ or less. If the density of the second thermoplastic resin layer is less than 1500 kg/m$^3$, the strength may be insufficient. On the other hand, if the density exceeds 2500 kg/m$^3$, the weight may be excessive.

Further, the second thermoplastic resin layer preferably has a flexural rigidity defined by {(flexural modulus (MPa) $\times$ thickness (mm)$^3$)/12} of 100 Mpa·mm$^3$ or more and 20000 Mpa·mm$^3$ or less, and more preferably 200 Mpa·mm$^3$ or more and 500 Mpa·mm$^3$ or less.

The method for forming the second thermoplastic resin layer is not particularly limited, and a known resin extrusion method or resin liquid impregnation method can be used.

Adhesion Layer

The back protective layer may comprise an adhesion layer at at least one position selected from: between the sealing layer and the first thermoplastic resin layer; between the first thermoplastic resin layer and the second thermoplastic resin layer; and on the surface of the second thermoplastic resin layer opposite to the surface on which the first thermoplastic resin layer is stacked.

The adhesive and the method for adhering the adhesion layer are not particularly limited. Examples include dry lamination, coextrusion, and extrusion coating, all of which use a two-component curable urethane-based adhesive, polyether urethane-based adhesive, polyester-based adhesive, polyester polyol-based adhesive, polyester-polyurethane polyol-based adhesive, etc.; heat-lamination that uses an anchor coating agent; and the like.

For bonding the first thermoplastic resin layer and the second thermoplastic resin layer, the thickness of the adhesion layer is preferably 3 $\mu$m or more and 100 $\mu$m or less, and particularly preferably 10 $\mu$m or more and 50 $\mu$m or less.

Weather-Resistant Layer

On the back surface of the second thermoplastic resin layer, another resin layer may be provided from the viewpoint of weatherability. The type of the resin is not particularly limited. For example, it is possible to use a film or sheet of polyolefin resins, such as polyethylene (high-density polyethylene, low-density polyethylene, linear low-density polyethylene), polypropylene, and polybutene, (meth)acrylic resin, polyvinyl chloride resin, polystyrene resin, polyvinylidene chloride resin, saponified ethylene-vinyl acetate copolymer, polyvinyl alcohol, polycarbonate resin, fluororesin (polyvinylidene fluoride, polyvinyl fluoride, ethylene-tetrafluoroethylene), polyvinyl acetate resin, acetal resin, polyester resin (polyethylene terephthalate, polybutylene terephthalate, polyethylene naphthalate), polyamide resin, polyphenylene ether resin, and other various resins.

These resin films or sheets may be stretched uniaxially or biaxially. Of these, polyester resin is preferable because electrical insulation, handling properties, and the like are securely obtained. Further, the resin layer can be appropriately colored in white, black, or the like. Examples of the coloring means include coating, film formation by pigment kneading, and the like. For the film-forming method, T-die molding or inflation molding is used. Molding with a multilayer extruder is also possible.

Colored Layer

The front surface of the first thermoplastic resin layer may have a resin layer containing an organic or inorganic pigment. The type of the resin is not particularly limited. For example, it is possible to use at least one film or sheet of polyolefin resins, such as polyethylene (high-density polyethylene, low-density polyethylene, linear low-density polyethylene), polypropylene, and polybutene, (meth)acrylic resin, polyvinyl chloride resin, polystyrene resin, polyvinylidene chloride resin, saponified ethylene-vinyl acetate copolymer, polyvinyl alcohol, polycarbonate resin, fluororesin (polyvinylidene fluoride, polyvinyl fluoride, ethylene-tetrafluoroethylene), polyvinyl acetate resin, acetal resin, polyester resin (polyethylene terephthalate, polybutylene terephthalate, polyethylene naphthalate), polyamide resin, polyphenylene ether resin, and other various resins. These resin films or sheets may be stretched uniaxially or biaxially.

Of these, polyethylene (high-density polyethylene, low-density polyethylene, linear low-density polyethylene) is preferable to securely obtain excellent adhesion with EVA, which is a sealing material of the solar cell module, and linear low-density polyethylene is more preferable. Linear low-density polyethylene (LLDPE), which has a higher density than low-density polyethylene (LDPE), is preferable for its excellent heat resistance and weatherability.

For the film-forming method, T-die molding or inflation molding is used. Molding with a multilayer extruder is also possible. Further, the resin layer can be appropriately colored in white, black, or the like. Examples of the coloring means include coating, film formation by pigment kneading, and the like.

Sum of Flexural Rigidity and Total Thickness

In the solar cell module of the present invention, the sum of flexural rigidity of each of the surface glass layer, the sealing layer (a single sealing layer obtained after the first sealing layer and second sealing layer are fused with each other), and the back protective layer (each of the first thermoplastic resin layer and the second thermoplastic resin layer) is 4000 Mpa·mm$^3$ or more (preferably 4000 to 30000 Mpa·mm$^3$). The flexural rigidity is defined by: {(flexural modulus (MPa) $\times$ thickness (mm)$^3$)/12}.

If the sum of the flexural rigidity of the surface glass layer, the first sealing layer, the second sealing layer, and the back protective layer is less than 4000 Mpa·mm$^3$, the deflection displacement of the module exceeds 50 mm due to the uniformly distributed load in a load test at 2400 Pa, possibly causing cracking of the cells.

Further, the solar cell module of the present invention preferably has a total thickness (total thickness of all of the layers excluding the cells) of 4 mm or more and less than 8 mm. If the total thickness is less than 4 mm, cell cracking may easily occur due to the bending displacement in a load test. The total thickness exceeding 8 mm will also affect the weight, and possibly cause an adverse effect during installation to a stand or during the production process.

Examples

The present invention is described in detail below with reference to Examples and Comparative Examples. However, the present invention is not limited to these Examples.

Example 1

First, a foamed polypropylene (PP) film having a foaming ratio of 3 times, a density of 400 kg/m$^3$, an elastic modulus of 400 MPa, and a thickness of 3 mm was prepared as a first thermoplastic resin layer; and a glass cloth-reinforced polypropylene resin-based FRP having a density of 1600 kg/m$^3$, an elastic modulus of 20000 MPa, and a thickness of 0.5 mm MPa (glass fiber density: 50 wt%) was prepared as a second thermoplastic resin layer.

Subsequently, these layers were bonded to each other with a commercially available urethane isocyanate-based adhesive, and a transparent polyethylene terephthalate (PET) film having a density of 1400 kg/m$^3$, an elastic modulus of 2400 MPa, and a thickness of 0.2 mm was further bonded to the other surface of the second thermoplastic resin layer to enhance insulation. For the bonding of these layers, a urethane isocyanate-based adhesive (thickness: 20 $\mu$m) was used. In this manner, a back protective layer was obtained.

Next, toughened glass having a density of 2500 kg/m$^3$, an elastic modulus of 60000 MPa, and a size of 1640 mm $\times$ 990 mm $\times$ 0.85 mm (thickness) was prepared as a surface glass layer; two EVAs having the same dimension as the surface glass layer, and having a density of 960 kg/m$^3$, an elastic modulus of 100 MPa, and a thickness of 0.5 mm were prepared as sealing materials; and 60 single-crystalline cells (3BB), each having a size of 156 mm $\times$ 156 mm $\times$ 200 $\mu$m (thickness) were prepared as cells. Then, a commercially available interconnector (Hitachi Metals, Ltd.) and bus bar (Hitachi Metals, Ltd.) were attached to the cells.

The surface glass layer, the sealing material, the cells, the sealing material, and the back protective layer were placed in sequence on a hot plate of a vacuum laminator (produced by NPC Incorporated), and lamination was carried out at 140°C for 20 minutes. The cells were arranged in 6 rows in the short direction and 10 rows in the longitudinal direction, with respect to the surface glass layer. In this manner, a solar cell module was obtained in which the surface glass layer, the sealing material, the cells, the sealing material, and the back protective layer ("foamed PP," "FRP," "PET") were stacked in sequence.

This solar cell module had a size of 1640 mm × 990 mm, a total module thickness (60-cell module) of 5.55 mm, and a weight of 9.7 kg.

The total flexural rigidity was $(60000 \times 0.85^3 + 100 \times 1^3 + 400 \times 3^3 + 20000 \times 0.5^3 + 2400 \times 0.2^3) \times (1/12)$ = 4189 Mpa·mm$^3$.

Next, evaluation tests based on IEC61215 and JIS C 8990 were performed for this solar cell module. For the evaluation tests, a load test was performed comprising 3 cycles of a test in which an uniformly distributed load of 2400 Pa was applied alternately to the front side and back side of the module for 1 hour each, and a hail test was performed in which an ice ball with a diameter of 25 mm was thrown at 11 different portions of the surface of the module at a rate of 23 m/s (the same applies hereinafter).

Those in which cracking occurred, or those in which the evaluation tests could not be performed due to warping of the solar cell module, were evaluated as "B"; while those in which cracking did not occur were evaluated as "A." Table 1 shows the results (the same applies hereinafter). The test results were both "A."

Example 2

A solar cell module was obtained as in Example 1, except that the thickness of the first thermoplastic resin layer was changed from 3 mm to 5 mm, and so the solar cell module had a total thickness of 7.55 mm, a weight of 11.0 kg, and a total flexural rigidity of 7456 Mpa·mm$^3$.

Next, the solar cell module evaluation tests were performed as in Example 1. The test results were both "A."

Example 3

A solar cell module was obtained as in Example 1, except that the thickness of the surface glass layer was changed from 0.85 mm to 1.6 mm, and so the solar cell module had a total thickness of 6.3 mm, a weight of 12.7 kg, and a total flexural rigidity of 21598 Mpa·mm$^3$.

Next, the solar cell module evaluation tests were performed as in Example 1. The test results were both "A."

Example 4

A solar cell module was obtained as in Example 1, except that a glass cloth-reinforced polypropylene resin-based FRP having a density of 1600 kg/m$^3$, an elastic modulus of 20000 MPa, and a thickness of 0.5 mm was further stacked between the sealing layer and the first thermoplastic resin layer, and so the solar cell module was such that the surface glass layer, the sealing material, the cells, the sealing material, and the back protective layer ("FRP," "foamed PP," "FRP," "PET") were stacked in sequence.

The solar cell module had a total thickness of 6.05 mm, a weight of 11.0 kg, and a total flexural rigidity of 4397 Mpa·mm$^3$.

Next, the solar cell module evaluation tests were performed as in Example 1. The test results were both "A."

Reference Example 1

A general solar cell module comprising a back protective sheet (back sheet) was obtained by using a conventional thick surface glass layer, without using a thin surface glass layer.

A solar cell module was obtained as in Example 1, except that toughened glass having a density of 2500 kg/m$^3$, an elastic modulus of 60000 MPa, and a thickness of 3.2 mm was used as the surface glass layer, and a back protective layer only comprising a transparent PET film having a density of 1400 kg/m$^3$, an elastic modulus of 2400 MPa, and a thickness of 0.2 mm was used as the back protective layer, and so the solar cell module was such that the surface glass layer, the sealing material, the cells, the sealing material, and the back protective sheet (PET film) were stacked in sequence.

The solar cell module had a total thickness of 4.4 mm, a weight of 16.0 kg, and a total flexural rigidity of 163850 Mpa· mm$^3$. The weight exceeded a weight that is usually considered to be possible for a woman to work with on her own (body weight: 55 kg × 60% × 40% = 13 kg).

Next, the solar cell module evaluation tests were performed as in Example 1. The test results were both "A."

Reference Example 2

A general solar cell module was obtained by using a conventional thick surface glass layer, without using a thin surface glass layer.

A solar cell module was obtained as in Example 1, except that toughened glass having a density of 2500 kg/m$^3$,

an elastic modulus of 60000 MPa, and a thickness of 3.2 mm was used as the surface glass layer, and a back protective layer only comprising, as the first thermoplastic resin, foamed polypropylene (PP) having a foaming ratio of 3 times, a density of 400 kg/m$^3$, an elastic modulus of 400 MPa, and a thickness of 3 mm was used as the back protective layer, and so the solar cell module was such that the surface glass layer, the sealing material, the cells, the sealing material, and the back protective layer (foamed PP) were stacked in sequence.

The solar cell module had a total thickness of 7.4 mm, a weight of 17.9 kg, and a total flexural rigidity of 164750 Mpa·mm$^3$. The weight exceeded a weight that is usually considered to be possible for a woman to work with on her own (body weight: 55 kg × 60% × 40% = 13 kg).

Next, the solar cell module evaluation tests were performed as in Example 1. The test results were both "A."

Comparative Example 1

A solar cell module was obtained as in Example 1, except that the surface glass layer having a thickness of 0.85 mm was changed to a resin sheet of a PET film having a thickness of 0.2 mm, and so the solar cell module had a total thickness of 4.9 mm, a weight of 7.1 kg, and a total flexural rigidity of 1120 Mpa·mm$^3$, and was such that the surface resin, the sealing material, the cells, the sealing material, and the back protective layer ("foamed PP," "FRP," "PET") were stacked in sequence.

Next, the solar cell module evaluation tests were performed as in Example 1. The results were both "B."

Comparative Example 2

A solar cell module was obtained as in Comparative Example 1, except that the thickness of the first thermoplastic resin layer was changed from 3 mm to 5 mm, and so the total thickness was 6.9 mm, the weight was 8.4 kg, and the total flexural rigidity was 4387 Mpa·mm$^3$.

Next, the solar cell module evaluation tests were performed as in Example 1. Although the load test result was "A," the hail test result was "B."

Comparative Example 3

A solar cell module was obtained as in Reference Example 1, except that the thickness of the surface glass layer was changed from 3.2 mm to 1.6 mm, and so the total thickness was 5.8 mm, the weight was 11.4 kg, and the total flexural rigidity was 21390 Mpa·mm$^3$.

Next, the solar cell module evaluation tests were performed as in Example 1. Since the solar cell module warped greatly, neither of the tests could be performed, and the results were both "B."

Comparative Example 4

A solar cell module was obtained as in Comparative Example 3, except that the thickness of the surface glass layer was changed from 1.6 mm to 0.85 mm, and so the total thickness was 5.1 mm, the weight was 8.6 kg, and the total flexural rigidity was 4555 Mpa·mm$^3$.

Next, the solar cell module evaluation tests were performed as in Example 1. Since the solar cell module warped greatly, neither of the tests could be performed, and the results were both "B."

Comparative Example 5

A solar cell module was obtained as in Example 1, except that toughened glass having a density of 2500 kg/m$^3$, an elastic modulus of 60000 MPa, and a thickness of 0.85 mm was used as the surface glass layer, and a back protective layer only comprising glass cloth-reinforced polypropylene resin-based FRP having a density of 1600 kg/m$^3$, an elastic modulus of 20000 MPa, and a thickness of 1.0 mm was used as the back protective layer, and so the solar cell module was such that the surface glass layer, the sealing material, the cells, the sealing material, and the back protective layer (FRP) were stacked in sequence.

The solar cell module had a total thickness of 3.1 mm, a weight of 9.2 kg, and a total flexural rigidity of 5322 Mpa·mm$^3$.

Next, the solar cell module evaluation tests were performed as in Example 1. The results were both "B."

Comparative Example 6

A solar cell module was obtained as in Reference Example 2, except that the thickness of the surface glass layer was changed from 3.2 mm to 1.6 mm, and so the total thickness was 2.8 mm, the weight was 9.5 kg, and the total flexural rigidity was 20490 Mpa·mm$^3$.

Next, the solar cell module evaluation tests were performed as in Example 1. Although the load test result was "A," the hail test result was "B."

Comparative Example 7

A solar cell module was obtained as in Comparative Example 6, except that the thickness of the surface glass layer was changed from 1.6 mm to 0.85 mm, and so the total thickness was 2.05 mm, the weight was 6.4 kg, and the total flexural rigidity was 3081 Mpa·mm$^3$.

Next, the solar cell module evaluation tests were performed as in Example 1. The results were both "B."

Table 1

| | Thickness of surface glass layer (mm) | Thickness of first thermoplastic resin layer (mm) | Thickness of second thermoplastic resin layer (mm) | Total thickness (mm) | Density of first thermoplastic resin layer (kg/m$^3$) | Density of second thermoplastic resin layer (kg/m$^3$) | Flexural modulus of first thermoplastic resin layer (MPa) | Flexural modulus of second thermoplastic resin layer (MPa) | Flexural rigidity Total | Cell cracking Load test | Cell cracking Hail test |
|---|---|---|---|---|---|---|---|---|---|---|---|
| Ex. 1 | 0.85 | 3 | 0.5 | 5.55 | 400 | 1600 | 400 | 20000 | 4189 | A | A |
| Ex. 2 | 0.85 | 5 | 0.5 | 7.55 | 400 | 1600 | 400 | 20000 | 7456 | A | A |
| Ex. 3 | 1.6 | 3 | 0.5 | 6.3 | 400 | 1600 | 400 | 20000 | 21598 | A | A |
| Ex.4 | 0.85 | 3.5 | 0.5 | 6.05 | 400 | 1600 | 400 | 20000 | 4397 | A | A |
| Ref. Ex. 1 | 3.2 | - | - | 4.4 | - | - | - | - | 163850 | A | A |
| Ref.Ex. 2 | 3.2 | 3 | - | 7.4 | 400 | - | 400 | - | 164750 | A | A |
| Com. Ex.1 | - | 3 | 0.5 | 4.9 | 400 | 1600 | 400 | 20000 | 1120 | B | B |
| Com. Ex. 2 | - | 5 | 0.5 | 6.9 | 400 | 1600 | 400 | 20000 | 4387 | A | B |
| Com. Ex. 3 | 1.6 | 3 | - | 5.8 | 400 | - | 400 | - | 21390 | B | B |
| Com. Ex. 4 | 0.85 | 3 | - | 5.05 | 400 | - | 400 | - | 4555 | B | B |
| Com. Ex. 5 | 0.85 | - | - | 3.05 | - | - | - | - | 5322 | B | B |
| Com. Ex. 6 | 1.6 | - | - | 2.8 | - | - | - | - | 20490 | A | B |
| Com. Ex. 7 | 0.85 | - | - | 2.05 | - | - | - | - | 3081 | B | B |

The above results revealed that the solar cell modules comprising, in sequence from a light-receiving surface side, a surface glass layer having a thickness of 0.8 mm or more and 1.6 mm or less, a first sealing layer, cells, a second sealing layer, and a back protective layer, wherein

(1) the back protective layer comprises, in sequence from a side closer to the second sealing layer, a first thermoplastic resin layer being in a foam state and having a flexural modulus of 200 MPa or more and 1000 MPa or less, and a second thermoplastic resin layer containing glass fiber and having a flexural modulus of 10000 MPa or more and 25000 MPa or less; and
(2) the sum of flexural rigidity of each of the surface glass layer, the first sealing layer, the second sealing layer, and the back protective layer is 4000 Mpa·mm$^3$ or more, the flexural rigidity being defined by:
{(flexural modulus (MPa) $\times$ thickness (mm)$^3$)/12}, were light and yet had rigidity sufficient to suppress cell cracking during transportation, during installation, and after installation.

Description of the Reference Numerals

1.    Solar cell module
10.    Surface glass layer
20.    First sealing layer
30.    Cell
40.    Second sealing layer
50.    Back protective layer
52.    First thermoplastic resin layer
54.    Second thermoplastic resin layer

**Claims**

1.    A solar cell module comprising, in sequence from a light-receiving surface side, a surface glass layer having a thickness of 0.8 mm or more and 1.6 mm or less, a first sealing layer, cells, a second sealing layer, and a back protective layer, wherein

(1) the back protective layer comprises, in sequence from a side closer to the second sealing layer, a first thermoplastic resin layer being in a foam state and having a flexural modulus of 200 MPa or more and 1000 MPa or less, and a second thermoplastic resin layer containing glass fiber and having a flexural modulus of 10000 MPa or more and 25000 MPa or less; and
(2) the sum of flexural rigidity of each of the surface glass layer, the first sealing layer, the second sealing layer, and the back protective layer is 4000 Mpa·mm$^3$ or more, the flexural rigidity being defined by:
{(flexural modulus (MPa) $\times$ thickness (mm)$^3$)/12}.

2.    The solar cell module according to claim 1, wherein the first thermoplastic resin layer contains a foam body of at least one resin selected from the group consisting of polyethylene, polypropylene, polystyrene, polyurethane, polyethylene terephthalate, polyvinyl chloride, and polymethyl methacrylate.

3.    The solar cell module according to claim 1 or 2, wherein the second thermoplastic resin layer contains a glass fiber-reinforced resin comprising a mixture of glass fiber and at least one resin selected from the group consisting of polyethylene, polypropylene, polyamide, polyurethane, polycarbonate, polymethyl methacrylate, polyethylene terephthalate, polybutylene terephthalate, acrylonitrile styrene, acrylonitrile butadiene styrene, polyacetal, polyphenylene sulfide, polyether sulfone, polyether ether ketone, and fluororesin.

4.    The solar cell module according to claim 1 or 2, wherein the first thermoplastic resin layer has a thickness of 2 mm or more and 6 mm or less, and a density of 100 kg/m$^3$ or more and 700 kg/m$^3$ or less.

5.    The solar cell module according to claim 1 or 2, wherein the second thermoplastic resin layer has a thickness of 0.5 mm or more and 2 mm or less, and contains the glass fiber in an amount of 30 wt% or more and 70 wt% or less.

Fig. 1

## INTERNATIONAL SEARCH REPORT

| International application No. |
|---|
| PCT/JP2018/033863 |

**A. CLASSIFICATION OF SUBJECT MATTER**
Int.Cl. H01L31/048(2014.01)i

According to International Patent Classification (IPC) or to both national classification and IPC

**B. FIELDS SEARCHED**

Minimum documentation searched (classification system followed by classification symbols)
Int.Cl. H01L31/02-31/078, H01L31/18-31/20, H01L51/42-51/48, H02S10/00-10/40,
H02S30/00-99/00, B29C44/00-44/60, B29C67/20-67/24, B29D30/20-30/72

| Documentation searched other than minimum documentation to the extent that such documents are included in the fields searched | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2015-15397 A (KOITO MANUFACTURING CO., LTD.) 22 January 2015, paragraphs [0005]-[0011], [0025]-[0050], fig. 3 (Family: none) | 1-5 |
| A | JP 2014-207251 A (FUJIPREAM CORPORATION) 30 October 2014, paragraphs [0004], [0007], [0013], [0016] & WO 2013/024738 A1 | 1-5 |
| A | JP 2016-28883 A (JSP CO., LTD.) 03 March 2016, paragraphs [0011], [0029], [0064] (Family: none) | 1-5 |

☒ Further documents are listed in the continuation of Box C.    ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 22 October 2018 (22.10.2018) | 30 October 2018 (30.10.2018) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

| International application No. |
|---|
| PCT/JP2018/033863 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 8-151485A (SEKISUI CHEMICAL CO., LTD.) 11 June 1996, paragraph [0034] (Family: none) | 1-5 |
| A | JP 2015-502659 A (GIGA SOLAR FPC) 22 January 2015 & US 2014/0290744 A1 & WO 2013/074224 A1 & CN 104040728 A & KR 10-2014-0095554 A | 1-5 |
| A | JP 2010-278256 A (MA PACKAGING CO., LTD.) 09 December 2010 (Family: none) | 1-5 |
| A | JP 2011-66172 A (SEKISUI CHEMICAL CO., LTD.) 31 March 2011 (Family: none) | 1-5 |
| A | US 2010/0326501 A1 (ZHAO, Ruofei) 30 December 2010 (Family: none) | 1-5 |

Form PCT/ISA/210 (continuation of second sheet) (January 2015)

**EP 3 686 938 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012519967 A
- JP 2015502659 A